Europäisches Patentamt

European Patent Office

Office européen des brevets

(19)

(11) Veröffentlichungsnummer: **0 077 417 B1**

(12) **EUROPÄISCHE PATENTSCHRIFT**

(45) Veröffentlichungstag der Patentschrift:
07.01.87

(21) Anmeldenummer: **81108624.8**

(22) Anmeldetag: **21.10.81**

(51) Int. Cl.⁴: **H 01 J 37/24**

(54) Hochkonstanter Strahlerzeuger für geladene Teilchen.

(43) Veröffentlichungstag der Anmeldung:
**27.04.83 Patentblatt 83/17**

(45) Bekanntmachung des Hinweises auf die Patenterteilung:
**07.01.87 Patentblatt 87/2**

(84) Benannte Vertragsstaaten:
**AT BE CH DE FR GB IT LI NL SE**

(56) Entgegenhaltungen:
**DE - A - 2 332 604**
**DE - B - 2 153 695**

(73) Patentinhaber: **DR.-ING. RUDOLF HELL GmbH,
Grenzstrasse 1-5, D-2300 Kiel 14 (DE)**

(72) Erfinder: **Beisswenger, Siegfried,
Albert-Einstein-Strasse 22, D-2308 Preetz (DE)**
Erfinder: **Boppel, Wolfgang, Waldweg 7a, D-2308 Preetz
(DE)**

**Beschreibung**

Technisches Gebiet

Die vorliegende Erfindung betrifft einen hochkonstanten Strahlerzeuger für geladene Teilchen mit einer beheizten Kathode, einer Hilfselektrode und einer durchbohrten Anode.

Zugrundeliegender Stand der Technik

Es sind bereits Elektronenstrahl-Erzeugungssysteme bekannt, bei denen der Strahlstrom mittels einer Hilfselektrode, die auch als Wehneltzylinder bezeichnet wird, steuerbar ist. Für verschiedene Anwendungszwecke, z.B. für Materialbearbeitung oder Elektronenstrahlmikroskopie oder Elektronenstrahllithographie wird eine hohe Konstanz des Elektronenstrahls gefordert, die aber in der Praxis bisher nicht in vollem Umfang gegeben ist. Es ist beispielsweise in WO 81/03579 (veröffentlicht 10.12.81) ein Elektronenstrahl-Erzeugungssystem mit einer beheizten Kathode, einer durchbohrten Anode und einer auf negativerem Potential als die Kathode liegenden Hilfselektrode vorgeschlagen worden, das dadurch gekennzeichnet ist, dass der Strahlstrom durch Bemessen der aktiven Fläche der Kathode und durch Regelung der Kathodenheizung auf konstante Temperatur bestimmt ist. Hierdurch wird erreicht, dass der Emissionsstrom konstant gehalten wird. Durch thermische Driften, die besonders in der Anlaufphase auftreten, ändert sich jedoch der Öffnungswinkel des Strahlkegels, da sich durch die Erwärmung des Systems der Abstand Kathode zu Anode ändert, wodurch sich auch die Form des elektrischen Beschleunigungsfeldes ändert. Die Änderungen sind so gross, dass sie sich störend bemerkbar machen.

Offenbarung der Erfindung

Der vorliegenden Erfindung liegt daher die Aufgabe zugrunde, einen hochkonstanten Strahlerzeuger zu schaffen, bei dem ein in Quellgrösse, Öffnungskegel und Strahlstrom konstanter Strahl zur*Verfügung steht.

Die Erfindung erreicht dies dadurch, dass eine den Strahl umgebende und mit einem Messwiderstand verbundene Messblende auf der der Kathode abgewandten Seite der Hilfselektrode vorgesehen ist, durch die ein Teil des durch die Hilfselektrode beeinflussten Strahlstroms ausblendbar ist, dass der Messwiderstand als Istwert-Geber mit einem an eine Referenzspannung angeschlossenen Regler verbunden ist und dass der Ausgang des Reglers im Sinne einer Konstanthaltung des durch die Blende ausgeblendeten Strahlstroms mit der Hilfselektrode verbunden ist. Je nach Lage der Messblende kann es günstig sein, die Messblende auf ein Potential zu legen, das vom Nullpotential des Elektronenstrahlerzeugungssystems verschieden ist. Eine vorteilhafte Weiterbildung der Erfindung besteht darin, dass die Blende als Faraday-Käfig ausgebildet ist. Eine weitere vorteilhafte Ausbildung der Erfindung besteht darin, dass die Anode des Systems als Messblende ausgebildet ist.

Kurze Beschreibung der Zeichnungen

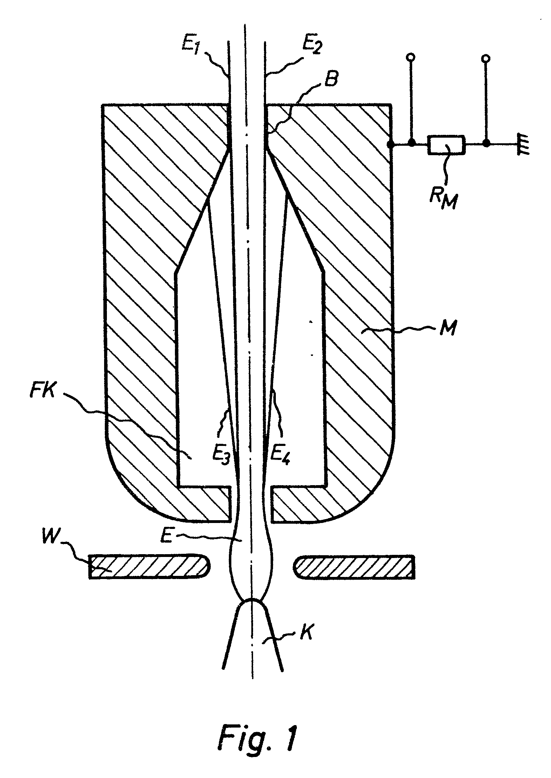

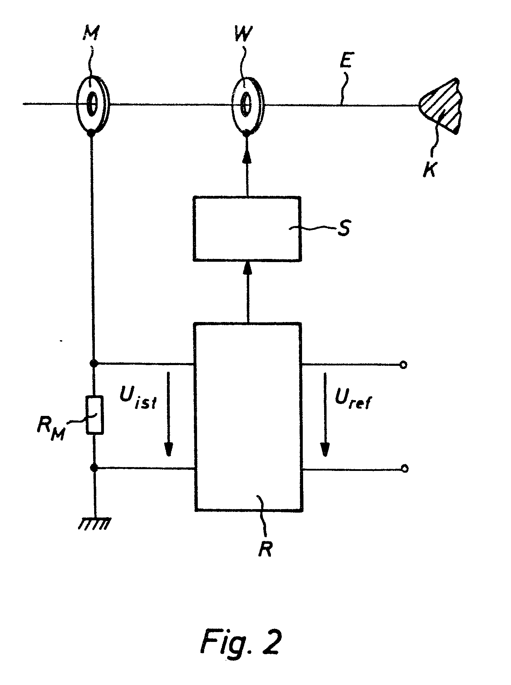

Die Erfindung wird im folgenden anhand der Figuren 1 und 2 näher erläutert. Es zeigen:

Figur 1: ein Beispiel für die Anordnung der Elektroden eines Elektronenstrahl-Erzeugungssystems

Figur 2: ein prinzipielles Schaltungsbeispiel zur Durchführung der Erfindung.

Bester Weg zur Ausführung der Erfindung

Figur 1 zeigt einen prinzipiellen Aufbau des Strahlerzeugungssystems, nämlich eine beheizte Kathode K, eine Hilfselektrode W und eine Messblende M, die den aus der Kathodenoberfläche austretenden Elektronenstrahl E umgibt. Die Messblende M ist über einen Messwiderstand $R_M$ mit einem konstanten Potential, z.B. dem Massepotential, verbunden und so ausgebildet, dass der Teil des Strahlstroms, der grösser als die Bohrung B der Blende ist, aufgefangen wird. Um den Wirkungsgrad dieser Blende konstant zu halten, ist der Raum vor der Blende in Richtung der Kathode ausserdem als Faraday-Käfig FK ausgeführt. Innerhalb des Strahlerzeugungssystems kann die Messblende M selbst die Anode sein oder die Anode kann in Strahlrichtung gesehen, vor oder nach der Messblende angeordnet sein. Ist der Strahl so gebündelt, dass er eine Grösse hat, die durch die Randstrahlen $E_1$ und $E_2$ dargestellt ist, so kann er die Blendenöffnung B ungehindert passieren. Ist der Strahl weiter aufgefächert, wie dies durch die Randstrahlen $E_3$ und $E_4$ dargestellt ist, so trifft er auf die Innenwand der Messblende M, und es fliesst ein Strom durch den Messwiderstand $R_M$ zum Bezugspotential.

Hierbei kann es vorteilhaft sein, dass die Messblende M auf einem Potential liegt, das vom Nullpotential des Elektronenstrahlerzeugungssystems verschieden ist.

Die Praxis zeigt, dass sich durch thermische Driften, vor allem in der Anlaufphase, der Abstand zwischen Kathode und Anode ändert. Bei fest eingestellter Spannung an der Hilfselektrode W, auch Wehneltzylinder genannt, verändert sich dadurch die Strahlgeometrie, und es kommt ohne die Messblende M und die erfindungsgemäss vorgesehene Regeleinrichtung dadurch zu einer Änderung der Strahlintensität.

In Figur 2 ist eine Schaltungsanordnung dargestellt, bei der der am Messwiderstand $R_M$ auftretende Ableitstrom, der an dem Messwiderstand $R_M$ einen Spannungsabfall $U_{ist}$ hervorruft, an einen Spannungsregler R gegeben wird, der seinerseits wiederum mit einer Referenzspannung $U_{ref}$ verbunden ist. Der Ausgang dieses Reglers ist weiterhin mit einem Stellglied S verbunden, das an die Hilfselektrode W eine Regelspannung abgibt, die dafür sorgt, dass die am Messwiderstand $R_M$ auftretende Spannung konstant gehalten wird.

Die hiermit erzielten Resultate lassen sich noch verbessern, wenn ein Elektronenstrahl-Erzeuger gemäss der WO 81/03579 verwendet wird, bei dem durch eine Regelung der Kathodentemperatur und Bemessung der aktiven Kathodenfläche dafür gesorgt wird, dass der totale Emissionsstrom konstant ist. Vereinigt man diese beiden Massnahmen, so ergibt sich ein Strahlerzeuger, der die geforderte hohe Konstanz aufweist.

Gewerbliche Verwertbarkeit

Die Erfindung kann mit Vorteil bei der Materialbearbeitung mit Elektronenstrahlen verwendet werden, wo es auf hohe Konstanz des Elektronenstrahls ankommt. Ein besonderes Anwendungsgebiet liegt auf dem Gebiet der Herstellung von Druckformen mittels Elektronenstrahlen, wobei der Elektronenstrahl in die Oberfläche der Druckform die für den Druckvorgang erforderlichen Näpfchen graviert. Ausserdem kann die Erfindung bei der Elektronenstrahlmikroskopie und der Elektronenstrahllithographie zur Herstellung hochpräziser Halbleiterbauelemente verwendet werden.

**Patentansprüche**

1. Elektronenstrahlerzeugungssystem mit hoher Konstanz des Strahlstroms und der Strahlgeometrie mit einer beheizten Kathode, einer Hilfselektrode (Wehneltelektrode) und einer durchbohrten Anode, dadurch gekennzeichnet, dass eine den Strahl (E) umgebende und mit einem Messwiderstand ($R_M$) verbundene Messblende (M) auf der der Kathode (K) abgewandten Seite der Hilfselektrode (W) vorgesehen ist, durch die ein Teil des durch die Hilfselektrode (W) beeinflussten Strahlstroms ausblendbar ist, dass der Messwiderstand ($R_M$) als Istwert-Geber mit einem an eine Referenzspannung ($U_{ref}$) angeschlossenen Regler (R) verbunden ist und dass der Ausgang des Reglers (R) mit einem Stellglied (S) verbunden ist, dessen Ausgang mit der Hilfselektrode (W) verbunden ist.

2. Elektronenstrahl-Erzeugungssystem nach Anspruch 1, dadurch gekennzeichnet, dass die Messblende (M) als Faraday-Käfig (FK) ausgebildet ist.

3. Elektronenstrahlerzeugungssystem nach Anspruch 1 oder 2, dadurch gekennzeichnet, dass die Messblende (M) auf einem Potential liegt, das vom Null-Potential des Elektronenstrahlerzeugungssystems verschieden ist.

4. Abänderung des Elektronenstrahlerzeugungssystems nach einem der Ansprüche 1 bis 3, dadurch gekennzeichnet, dass die Anode des Systems als Messblende (M) ausgebildet ist.

5. Elektronenstrahlerzeuger nach einem der Ansprüche 1 bis 4, dadurch gekennzeichnet, dass der Strahlstrom durch Bemessen der aktiven Fläche der Kathode und durch Regelung der Kathodenheizung auf konstante Temperatur bestimmt ist.

**Claims**

1. Electron beam generator system having a high constancy of the beam flux and of the beam geometry, comprising a heated cathode, an auxiliary electrode (Wehnelt electrode) and a transpierced anode, characterised in that a mensuration aperture (M) surrounding the beam (E) and connected to a mensuration resistor ($R_M$) is provided on the side of the auxiliary electrode (W) facing away from the cathode (K), whereby a proportion of the beam current influenced by the auxiliary electrode (W) may be gated out, in that the mensuration resistor ($R_M$) acting as an actual value transmitter is coupled to a regulator (R) connected to a reference voltage ($U_{ref}$) and that the output of the regulator (R) is connected to a setting element (S) whose output side is connected to the auxiliary electrode (W).

2. Electron generator system according to claim 1, characterised in that the mensuration aperture (M) is constructed as a Faraday cage (FK).

3. Electron beam generator system according to claim 1 or 2, characterised in that the mensuration aperture (M) is placed at a potential which differs from the zero potential of the electron beam generator system.

4. Modification of the electron beam generator system according to one of the claims 1 to 3, characterised in that the anode of the system is constructed as a mensuration aperture (M).

5. Electron beam generator system according to one of the claims 1 to 4, characterised in that the beam flux is determined by dimensioning of the active area of the cathode and by regulating the cathode heating to a constant temperature.

**Revendications**

1. Système-générateur de faisceau d'électrons, faisceau dont le courant et la géométrie sont très constants, avec une cathode chaude, une électrode auxiliaire (Wehnelt) et une anode perforée, caractérisé par un diaphragme de mesure (M) entourant le faisceau (E) et relié à une résistance de mesure ($R_M$), prévu du côté de l'électrode auxiliaire (W) opposé à celui de la cathode (K), diaphragme qui permet d'éliminer une partie du courant du faisceau influencé par l'électrode auxiliaire (W), en ce que la résistance de mesure ($R_M$) est reliée comme générateur de valeur réelle à un régulateur (R) relié à une tension de référence ($U_{ref}$), et en ce que la sortie du régulateur (R) est reliée à un élément de réglage (S) dont la sortie est reliée à l'électrode auxiliaire (W).

2. Système-générateur de faisceau d'électrons selon la revendication 1, caractérisé en ce que le diaphragme de mesure (M) est réalisé sous la forme d'une cage de Faraday (FK).

3. Système-générateur de faisceau d'électrons selon la revendication 1 ou 2, caractérisé en ce que le diaphragme de mesure (M) est à un potentiel qui est différent du potentiel zéro du système-générateur de faisceau d'électrons.

4. Variante du système-générateur de faisceau d'électrons selon l'une des revendications 1 à 3, caractérisée en ce que l'anode du système est réalisée sous la forme d'un diaphragme de mesure (M).

5. Générateur de faisceau d'électrons selon l'une des revendications 1 à 4, caractérisé en ce que le faisceau d'électrons est déterminé par la mesure de la surface active de la cathode et par régulation du chauffage de la cathode à une température constante.

*Fig. 1*

Fig. 2